# EUROPEAN PATENT SPECIFICATION

(11) **EP 4 241 314 B1**
(45) Date of publication and mention of the grant of the patent: **28.01.2026**
(21) Application number: 21815802.0
(22) Date of filing: 03.11.2021
(51) Int. Cl.: H10F 77/20, H10F 19/33, H10F 19/35

(54) **PHOTOVOLTAIC DEVICES WITH CONDUCTING LAYER INTERCONNECTS**
FOTOVOLTAISCHE VORRICHTUNGEN MIT LEITENDEN SCHICHTVERBINDUNGEN
DISPOSITIFS PHOTOVOLTAÏQUES AVEC INTERCONNEXIONS DE COUCHES CONDUCTRICES

(30) Priority: 03.11.2020 US 202063109261 P
(43) Date of publication of application: 13.09.2023
(73) Proprietor: First Solar, Inc., Tempe, AZ 85288 (US)
(72) Inventor: BHANDARI, Nikhil, Perrysburg, OH 43551 (US); DAVIS, Matthew, Perrysburg, OH 43551 (US); MILLER, Rhett, Perrysburg, OH 43551 (US); WICKERSHAM, Charles, Perrysburg, OH 43551 (US)
(74) Representative: D Young & Co LLP
(86) International application number: PCT/US2021/057867
(87) International publication number: WO 2022/098735

(56) References cited:
- US-A1- 2009 301 543
- US-A1- 2011 126 886
- US-A1- 2012 234 366

## Description

### BACKGROUND

The present specification generally relates to photovoltaic devices with conducting layer interconnects and, more specifically, to photovoltaic cells having conducting layer interconnects for forming electrical connections between neighboring cells of photovoltaic devices.

A photovoltaic device generates electrical power by converting light into electricity using semiconductor materials that exhibit the photovoltaic effect. Photovoltaic devices include a number of layers divided into a plurality of photovoltaic cells by selective removal of certain regions of the layers. Each photovoltaic cell converts sunlight into electrical power and can be electrically connected with one or more neighboring cells. Such electrical connections can be formed by filling the removed regions with conductive materials. The dimensions of the removed regions and the conductive materials can impact the performance and manufacturability of the photovoltaic device. US2012234366A1 and US2011126886A1 disclose forming a contact region in a conductive layer using a laser.

Accordingly, a need exists for alternative photovoltaic devices with conducting layer interconnects.

### SUMMARY

The embodiments provided herein relate to photovoltaic devices with conducting layer interconnects. These and additional features provided by the embodiments described herein will be more fully understood in view of the following detailed description, in conjunction with the drawings.

A photovoltaic cell according to the present invention is defined by the subject-matter of claim 1, and a method of forming a photovoltaic cell according to the present invention is defined by the subject-matter of claim 11.

### BRIEF DESCRIPTION OF THE DRAWINGS

The embodiments set forth in the drawings are illustrative and exemplary in nature and not intended to limit the subject matter defined by the claims. The following detailed description of the illustrative embodiments can be understood when read in conjunction with the following drawings, where like structure is indicated with like reference numerals and in which:
FIG. 1 schematically depicts a photovoltaic device according to one or more embodiments shown and described herein;
FIG. 2 schematically depicts a cross-sectional view along 2-2 of the photovoltaic device of FIG. 1 according to one or more embodiments shown and described herein;
FIG. 3 schematically depicts a substrate according to one or more embodiments shown and described herein;
FIG. 4 schematically depicts a process for forming a conducting layer interconnect according to one or more embodiments shown and described herein;
FIG. 5 graphically depicts a top perspective view of a via according to one or more embodiments shown and described herein; and
FIG. 6 schematically depicts a cross-sectional view along 6-6 of the via of FIG. 5 according to one or more embodiments shown and described herein.

### DETAILED DESCRIPTION

Embodiments of photovoltaic devices having reverse bias control are provided herein. Generally, the photovoltaic devices provided herein can include cells configured to limit the amount of power dissipated by the cells, when exposed to a reverse bias condition. Various embodiments of the photovoltaic device, as well as, systems and methods for forming the photovoltaic device will be described in more detail herein.

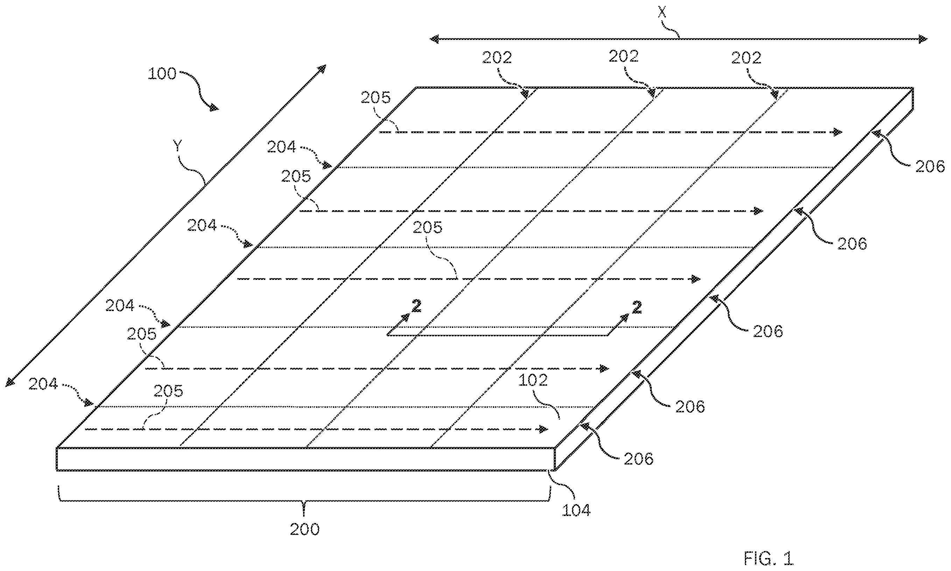

Referring now to FIG. 1, an embodiment of a photovoltaic device 100 is schematically depicted. The photovoltaic device 100 can be configured to receive light and transform light into electrical signals, e.g., photons can be absorbed from the light and transformed into electrical signals via the photovoltaic effect. Accordingly, the photovoltaic device 100 can define a first side 102 configured to be exposed to a light source such as, for example, the sun. The photovoltaic device 100 can also define an opposing side 104 offset from the first side 102 such as, for example, by a plurality of material layers. It is noted that the term "light" can refer to various wavelengths of the electromagnetic spectrum such as, but not limited to, wavelengths in the ultraviolet (UV), infrared (IR), and visible portions of the electromagnetic spectrum. "Sunlight," as used herein, refers to light emitted by the sun.

The photovoltaic device 100 can include a plurality of layers disposed between the first side 102 and the opposing side 104. As used herein, the term "layer" refers to a thickness of material provided upon a surface. Each layer can cover all or any portion of the surface. In some embodiments, the layers of the photovoltaic device 100 can be divided into an array of photovoltaic cells 200. For example, the photovoltaic device 100 can be scribed according to a plurality of serial scribes 202 and a plurality of parallel scribes 204. The serial scribes 202 can extend along a length Y of the photovoltaic device 100 and demarcate the photovoltaic cells 200 along the length Y of the photovoltaic device 100. The serial scribes 202 can be configured to connect neighboring cells of the photovoltaic cells 200 serially along a width X of the photovoltaic device 100. Serial scribes 202 can form a monolithic interconnect of the neighboring cells, i.e., adjacent to the serial scribe 202. The parallel scribes 204 can extend along the width X of the photovoltaic device 100 and demarcate the photovoltaic cells 200 along the width X of the photovoltaic device 100. Under operations, current 205 can predominantly flow along the width X through the photovoltaic cells 200 serially connected by the serial scribes 202. Under operations, parallel scribes 204 can limit the ability of current 205 to flow along the length Y. Parallel scribes 204 are optional and can be configured to separate the photovoltaic cells 200 that are connected serially into groups 206 arranged along length Y. Accordingly, the serial scribes 202 and the parallel scribes 204 can demarcate the array of the photovoltaic cells 200.

Referring still to FIG. 1, the parallel scribes 204 can electrically isolate the groups 206 of photovoltaic cells 200 that are connected serially. In some embodiments, the groups 206 of the photovoltaic cells 200 can be connected in parallel such as, for example, via electrical bussing. Optionally, the number of parallel scribes 204 can be configured to limit a maximum current generated by each group 206 of the photovoltaic cells 200. In some embodiments, the maximum current generated by each group 206 can be less than or equal to about 200 milliamps (mA) such as, for example, less than or equal to about 100 mA in one embodiment, less than or equal to about 75 mA in another embodiment, or less than or equal to about 50 mA in a further embodiment.

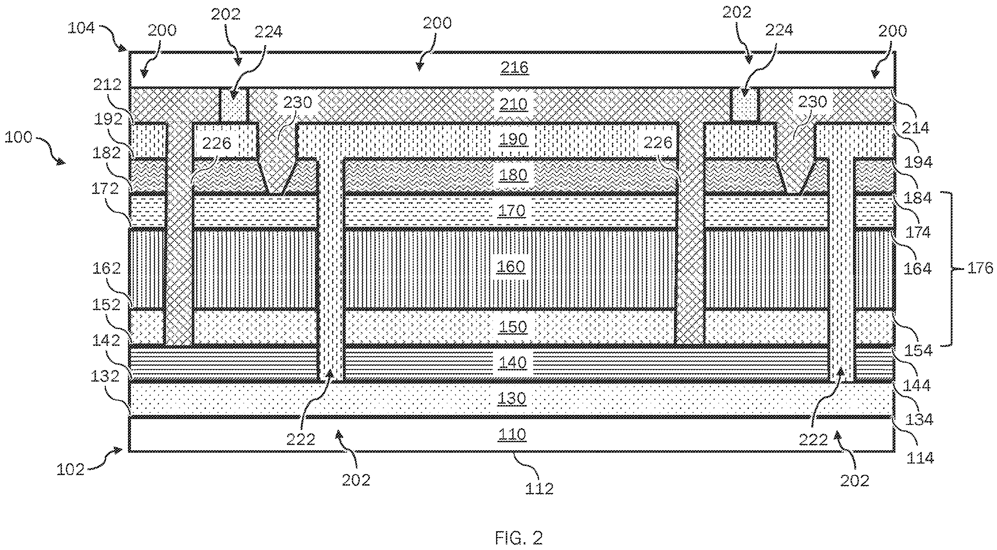

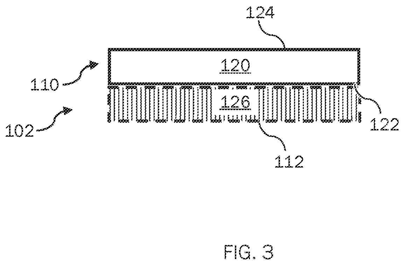

Referring collectively to FIGS. 1 and 2, the layers of the photovoltaic device 100 can include a substrate 110 configured to facilitate the transmission of light into the photovoltaic device 100. The substrate 110 can be disposed at the first side 102 of the photovoltaic device 100. Referring now to FIGS. 2 and 3, the substrate 110 can have a first surface 112 substantially facing the first side 102 of the photovoltaic device 100 and a second surface 114 substantially facing the opposing side 104 of the photovoltaic device 100. One or more layers of material can be disposed between the first surface 112 and the second surface 114 of the substrate 110.

The substrate 110 can include a transparent layer 120 having a first surface 122 substantially facing the first side 102 of the photovoltaic device 100 and a second surface 124 substantially facing the opposing side 104 of the photovoltaic device 100. In some embodiments, the second surface 124 of the transparent layer 120 can form the second surface 114 of the substrate 110. The transparent layer 120 can be formed from a substantially transparent material such as, for example, glass. Suitable glass can include soda-lime glass, or any glass with reduced iron content. The transparent layer 120 can have any suitable transmittance, including about 250 nm to about 1,300 nm in some embodiments, or about 250 nm to about 950 nm in other embodiments. The transparent layer 120 may also have any suitable transmission percentage, including, for example, more than about 50% in one embodiment, more than about 60% in another embodiment, more than about 70% in yet another embodiment, more than about 80% in a further embodiment, or more than about 85% in still a further embodiment. In one embodiment, transparent layer 120 can be formed from a glass with about 90% transmittance, or more. Optionally, the substrate 110 can include a coating 126 applied to the first surface 122 of the transparent layer 120. The coating 126 can be configured to interact with light or to improve durability of the substrate 110 such as, but not limited to, an antireflective coating, an antisoiling coating, or a combination thereof.

Referring again to FIG. 2, the photovoltaic device 100 can include a barrier layer 130 configured to mitigate diffusion of contaminants (e.g. sodium) from the substrate 110, which could result in degradation or delamination. The barrier layer 130 can have a first surface 132 substantially facing the first side 102 of the photovoltaic device 100 and a second surface 134 substantially facing the opposing side 104 of the photovoltaic device 100. In some embodiments, the barrier layer 130 can be provided adjacent to the substrate 110. For example, the first surface 132 of the barrier layer 130 can be provided upon the second surface 114 of the substrate 100. The phrase "adjacent to," as used herein, means that two layers are disposed contiguously and without any intervening materials between at least a portion of the layers.

Generally, the barrier layer 130 can be substantially transparent, thermally stable, with a reduced number of pin holes and having high sodium-blocking capability, and good adhesive properties. Alternatively or additionally, the barrier layer 130 can be configured to apply color suppression to light. The barrier layer 130 can include one or more layers of suitable material, including, but not limited to, tin oxide, silicon dioxide, aluminum-doped silicon oxide, silicon oxide, silicon nitride, or aluminum oxide. The barrier layer 130 can have any suitable thickness bounded by the first surface 132 and the second surface 134, including, for example, more than about 100 Å in one embodiment, more than about 150 Å in another embodiment, or less than about 200 Å in a further embodiment.

Referring still to FIG. 2, the photovoltaic device 100 can include a transparent conductive oxide (TCO) layer 140 configured to provide electrical contact to transport charge carriers generated by the photovoltaic device 100. The TCO layer 140 can have a first surface 142 substantially facing the first side 102 of the photovoltaic device 100 and a second surface 144 substantially facing the opposing side 104 of the photovoltaic device 100. In some embodiments, the TCO layer 140 can be provided adjacent to the barrier layer 130. For example, the first surface 142 of the TCO layer 140 can be provided upon the second surface 134 of the barrier layer 130. Generally, the TCO layer 140 can be formed from one or more layers of n-type semiconductor material that is substantially transparent and has a wide band gap. Specifically, the wide band gap can have a larger energy value compared to the energy of the photons of the light, which can mitigate undesired absorption of light. The TCO layer 140 can include one or more layers of suitable material, including, but not limited to, tin dioxide, doped tin dioxide (e.g., F-SnO₂), indium tin oxide, doped or undoped zinc oxide or cadmium stannate.

The photovoltaic device 100 can include a buffer layer 150 configured to provide an insulating layer between the TCO layer 140 and any adjacent semiconductor layers. The buffer layer 150 can have a first surface 152 substantially facing the first side 102 of the photovoltaic device 100 and a second surface 154 substantially facing the opposing side 104 of the photovoltaic device 100. In some embodiments, the buffer layer 150 can be provided adjacent to the TCO layer 140. For example, the first surface 152 of the buffer layer 150 can be provided upon the second surface 144 of the TCO layer 140. The buffer layer 140 may include material having higher resistivity than the TCO later 140, including, but not limited to, intrinsic tin dioxide, zinc magnesium oxide (e.g., Zn₁₋ₓMgₓO), silicon dioxide (SiO₂), aluminum oxide (Al₂O₃), aluminum nitride (AlN), zinc tin oxide, zinc oxide, tin silicon oxide, or any combination thereof. In some embodiments, the material of the buffer layer 140 can be configured to substantially match the band gap of an adjacent semiconductor layer (e.g., an absorber). The buffer layer 150 may have any suitable thickness between the first surface 152 and the second surface 154, including, for example, more than about 100 Å in one embodiment, between about 100 Å and about 800 Å in another embodiment, or between about 150 Å and about 600 Å in a further embodiment.

Referring still to FIG. 2, the photovoltaic device 100 can include an absorber layer 160 configured to cooperate with another layer and form a p-n junction within the photovoltaic device 100. Accordingly, absorbed photons of the light can free electron-hole pairs and generate carrier flow, which can yield electrical power. The absorber layer 160 can have a first surface 162 substantially facing the first side 102 of the photovoltaic device 100 and a second surface 164 substantially facing the opposing side 104 of the photovoltaic device 100. A thickness of the absorber layer 160 can be defined between the first surface 162 and the second surface 164. The thickness of the absorber layer 160 can be between about 0.5 µm to about 10 µm such as, for example, between about 1 µm to about 7 µm in one embodiment, or between about 1.5 µm to about 4 µm in another embodiment.

According to the embodiments described herein, the absorber layer 160 can be formed from a p-type semiconductor material having an excess of positive charge carriers, i.e., holes or acceptors. The absorber layer 160 can include any suitable p-type semiconductor material such as group II-VI semiconductors. Specific examples include, but are not limited to, semiconductor materials comprising cadmium, tellurium, selenium, or any combination thereof. Suitable examples include, but are not limited to, binaries of cadmium and tellurium, ternaries of cadmium, selenium and tellurium (e.g., CdSeₓTe₁₋ₓ), ternaries of cadmium, zinc, and tellurium (e.g., CdZnₓTe₁₋ₓ), a compound comprising cadmium, selenium, tellurium, and one or more additional element, or a compound comprising cadmium, zinc, tellurium, and one or more additional element.

In embodiments where the absorber layer 160 comprises tellurium and cadmium, the atomic percent of the tellurium can be greater than or equal to about 25 atomic percent and less than or equal to about 50 atomic percent such as, for example, greater than about 30 atomic percent and less than about 50 atomic percent in one embodiment, greater than about 40 atomic percent and less than about 50 atomic percent in a further embodiment, or greater than about 47 atomic percent and less than about 50 atomic percent in yet another embodiment. Alternatively or additionally, the atomic percent of the tellurium in the absorber layer 160 can be greater than about 45 atomic percent such as, for example, greater than about 49% in one embodiment. It is noted that the atomic percent described herein is representative of the entirety of the absorber layer 160, the atomic percentage of material at a particular location within the absorber layer 160 can vary with thickness compared to the overall composition of the absorber layer 160.

In embodiments where the absorber layer 160 comprises selenium and tellurium, the atomic percent of the selenium in the absorber layer 160 can be greater than about 0 atomic percent and less or equal to than about 25 atomic percent such as, for example, greater than about 1 atomic percent and less than about 20 atomic percent in one embodiment, greater than about 1 atomic percent and less than about 15 atomic percent in another embodiment, or greater than about 1 atomic percent and less than about 8 atomic percent in a further embodiment. It is noted that the concentration of tellurium, selenium, or both can vary through the thickness of the absorber layer 160. For example, when the absorber layer 160 comprises a compound including selenium at a mole fraction of x and tellurium at a mole fraction of 1-x (SeₓTe₁₋ₓ), x can vary in the absorber layer 160 with distance from the first surface 162 of the absorber layer 160.

Referring still to FIG. 2, the absorber layer 160 can be doped with a dopant configured to manipulate the charge carrier concentration. In some embodiments, the absorber layer 160 can be doped with a group I or V dopant such as, for example, copper, arsenic, phosphorous, antimony, or a combination thereof. The total density of the dopant within the absorber layer 160 can be controlled. Alternatively or additionally, the amount of the dopant can vary with distance from the first surface 162 of the absorber layer 160.

According to the embodiments provided herein, the p-n junction can be formed by providing the absorber layer 160 sufficiently close to a portion of the photovoltaic device 100 having an excess of negative charge carriers, i.e., electrons or donors. In some embodiments, the absorber layer 160 can be provided adjacent to n-type semiconductor material. Alternatively, one or more intervening layers can be provided between the absorber layer 160 and n-type semiconductor material. In some embodiments, the absorber layer 160 can be provided adjacent to the buffer layer 150. For example, the first surface 162 of the absorber layer 160 can be provided upon the second surface 154 of the buffer layer 150.

The photovoltaic device 100 can include a back contact layer 170 configured to mitigate undesired alteration of the dopant and to provide electrical contact to the absorber layer 160. The back contact layer 170 can have a first surface 172 substantially facing the first side 102 of the photovoltaic device 100 and a second surface 174 substantially facing the opposing side 104 of the photovoltaic device 100. A thickness of the back contact layer 170 can be defined between the first surface 172 and the second surface 174. The thickness of the back contact layer 170 can be between about 5 nm to about 200 nm such as, for example, between about 10 nm to about 50 nm in one embodiment.

In some embodiments, the back contact layer 170 can be provided adjacent to the absorber layer 160. For example, the first surface 172 of the back contact layer 170 can be provided upon the second surface 164 of the absorber layer 160. In some embodiments, the back contact layer 170 can include binary or ternary combinations of materials from groups I, II, VI, such as for example, one or more layers containing zinc, copper, cadmium and tellurium in various compositions. Further exemplary materials include, but are not limited to, zinc telluride doped with copper telluride, or zinc telluride alloyed with copper telluride. For ease of discussion, a stack of layers including the buffer layer 150, the absorber layer 160, the back contact layer 170, or a combination thereof, may be referred to herein as a semiconductor stack 176.

The photovoltaic device 100 can include a first conducting layer 180 configured to provide electrical contact with the absorber layer 160. The first conducting layer 180 can have a first surface 182 substantially facing the first side 102 of the photovoltaic device 100 and a second surface 184 substantially facing the opposing side 104 of the photovoltaic device 100. In some embodiments, the first conducting layer 180 can be provided adjacent to the back contact layer 170. For example, the first surface 182 of the first conducting layer 180 can be provided upon the second surface 174 of the back contact layer 170. A thickness of the first conducting layer 180 can be defined between the first surface 182 and the second surface 184. The thickness of the first conducting layer 180 can be less than about 3 µm such as, for example, between about 50 nm to about 2.5 µm in one embodiment, or between about 100 nm to about 2 µm in another embodiment.

The first conducting layer 180 can include any suitable conducting material having a sheet resistance between 0.5 Ω/sq and 10 Ω/sq. Suitable examples include one or more layers of metal, one or one or more layers of nitrogen-containing metal, or both. Alternatively or additionally, the first conducting layer 180 can be transparent or transparent to certain wavelengths of light. In some embodiments, the first conducting layer 180 can include a combination of layers conducting material. Each layer can contribute structural or electrical characteristics such that the stack of layers of conductive material have desired performance characteristics. Suitable metals include, but are not limited to, silver, nickel, copper, aluminum, titanium, palladium, chrome, molybdenum, gold, or combinations thereof. Suitable examples of a nitrogen-containing metals include, but are not limited to, aluminum nitride, nickel nitride, titanium nitride, tungsten nitride, selenium nitride, tantalum nitride, or vanadium nitride.

The photovoltaic device 100 can include a dielectric layer 190 configured to electrically isolate one or more layers of the photovoltaic device 100. For example, within a cell 200, the dielectric layer 190 can electrically isolate the first conducting layer 180 from a second conducting layer 210. The dielectric layer 190 can have a first surface 190 substantially facing the first side 102 of the photovoltaic device 100 and a second surface 194 substantially facing the opposing side 104 of the photovoltaic device 100. In some embodiments, the dielectric layer 190 can be provided adjacent to the first conducting layer 180. For example, the first surface 192 of the dielectric layer 190 can be provided upon the second surface 184 of the first conducting layer 180. A thickness of the dielectric layer 190 can be defined between the first surface 192 and the second surface 194. The thickness of the dielectric layer 190 can be less than about 30 µm such as, for example, less than about 20 µm in one embodiment. Generally, the thickness of the dielectric layer 190 is at least one order of magnitude larger than the thickness of the first conducting layer 180 such as, for example, greater than about 25 times the thickness of the first conducting layer 180 in one embodiment, greater than about 50 times the thickness of the first conducting layer 180 in another embodiment, or greater than about 100 times the thickness of the first conducting layer 180 in a further embodiment.

The dielectric layer can include a dielectric material such as, for example, a photoresist material or a non-conductive polymer. Suitable example dielectric material can further include epoxy, acrylic, phenolic, polyimide, or the like. In some embodiments, the dielectric material can have greater than about 10% transmissivity to wavelengths of light suitable for use for laser ablation, i.e., the wavelength range can be associated with solid state laser wavelengths. For example, the wavelength range can be between about 300 nm and about 1,100 nm.

Referring still to FIG. 2, photovoltaic device 100 can include a second conducting layer 210 configured to provide electrical contact with the TCO layer 140, the first conducting layer 180 of a neighboring cell 200, or both. The second conducting layer 210 can have a first surface 212 substantially facing the first side 102 of the photovoltaic device 100 and a second surface 214 substantially facing the opposing side 104 of the photovoltaic device 100. In some embodiments, the second conducting layer 210 can be provided adjacent to the dielectric layer 190. For example, the first surface 212 of the second conducting layer 210 can be provided upon the second surface 194 of the of the dielectric layer 190. A thickness of the second conducting 210 can be defined between the first surface 212 and the second surface 214. A thickness of the first conducting layer 180 can be defined between the first surface 182 and the second surface 184. The thickness of the second conducting layer 210 can be less than about 3 µm such as, for example, between about 50 nm to about 2.5 µm in one embodiment, or between about 100 nm to about 2 µm in another embodiment. The second conducting layer 210 can include any suitable conducting material having a sheet resistance between 0.5 Ω/sq and 10 Ω/sq. Suitable examples include one or more layers of metal, one or one or more layers of nitrogen-containing metal, or both, as described above with respect to the first conducting layer 180. Alternatively or additionally, the second conducting layer 190 can be transparent or transparent to certain wavelengths of light. In some embodiments, the second conducting layer 210 can have a different material composition than the first conducting layer 180. Alternatively or additionally, the first conducting layer 180, the second conducting layer 190, or both can include non-metal materials such as, for example, oxides.

The photovoltaic device 100 can include a back support 216 configured to cooperate with the substrate 110 to form a housing for the photovoltaic device 100. The back support 216 can be disposed at the opposing side 104 of the photovoltaic device 100. For example, the back support 216 can be formed over the second conducting layer 210. The back support 216 can include any suitable material, including, for example, glass (e.g., soda-lime glass). It should be noted that the term "over" can mean that an object or a first layer is attached directly or indirectly to a surface of a second layer. Accordingly, a first layer that is "over" a second layer can be attached directly to the surface of the second layer or attached to one or more intervening objects or layers at a position that is offset from the surface of the second layer.

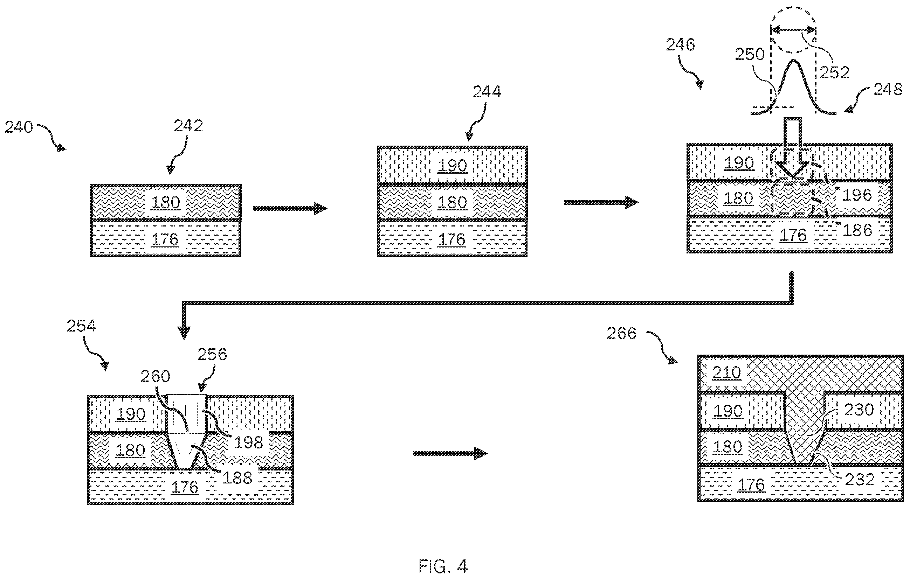

Referring collectively to FIGS. 2 and 4, manufacturing of a photovoltaic device 100 generally includes sequentially disposing functional layers or layer precursors in a "stack" of layers through one or more thin film deposition processes, including, but not limited to, sputtering, spray, evaporation, molecular beam deposition, pyrolysis, closed space sublimation (CSS), pulse laser deposition (PLD), chemical vapor deposition (CVD), electrochemical deposition (ECD), atomic layer deposition (ALD), or vapor transport deposition (VTD). In some embodiments, VTD may be preferred for greater through put quality.

Manufacturing of photovoltaic devices 100 can further include the selective removal of the certain regions of the stack of layers, i.e., scribing or ablation, to divide the photovoltaic device into 100 a plurality of photovoltaic cells 200. For example, the serial scribes 202 can comprise a first isolation scribe 222 (also referred to as P1 scribe), and a second isolation scribe 224 (also referred to as P3 scribe). The first isolation scribe 222 can be formed to ensure that the TCO layer 140 is electrically isolated between neighboring cells 200. Specifically, the first isolation scribe 222 can be formed though the TCO layer 140, the buffer layer 150, and the absorber layer 160 of photovoltaic device 100. The second isolation scribe 224 can be formed to isolate the conducting layer 180 into individual cells 200. The second isolation scribe 224 can be formed through the second conducting layer 210. The first isolation scribe 222, the second isolation scribe 224, or both can be filled with a dielectric material.

A cell interconnect 226 can be formed to electrically connect layers of a photovoltaic cell 200. The cell interconnect 226 can be configured to electrically connect the TCO layer 140 with the second conducting layer 210. In some embodiments, the cell interconnect 226 can be formed though and electrically isolated from some or all of the semiconductor stack 176. The cell interconnect 226 can be formed with a conducting material such as, but not limited to, the material of the second conducting layer 210.

Referring collectively to FIGS. 1 and 2, a conducting layer interconnect 230 can be formed to electrically connect layers of the photovoltaic cell 200. As described herein, the conducting layer interconnect 230 can be configured to electrically connect the first conducting layer 180 and with the second conducting layer 210. Specifically, the conducting layer interconnect 230 can be configured to form selective points of electrical contact between the first conducting layer 180 and the second conducting layer 210, while the majority of the first conducting layer 180 and the second conducting layer 210 are electrically isolated by the dielectric layer 190. The conducting layer interconnect 230 can include any suitable conducting material such as, for example, one or more layers of metal, one or one or more layers of nitrogen-containing metal, or both, as described above with respect to the first conducting layer 180. In some embodiments, the conducting layer interconnect 230 can comprise one or more dissimilar materials than the first conducting layer 180. For example, the conducting layer interconnect 230 can comprise a conductive material not present in the first conducting layer 180.

In some embodiments, the photovoltaic cell 200 can include a plurality of conducting layer interconnects 230 each configured to allow a desired amount of current to flow between the first conducting layer 180 and the second conducting layer 210. For example, the number of conducting layer interconnects 230 in each cell 200 and the desired amount of current flowing through each of the conducting layer interconnects 230 can correspond to the current 205 generated by the group 206 of serially connected photovoltaic cells 200. Thus, the quantity of the conducting layer interconnects 230 can be scaled in accordance with the current 205 generated by the group 206 of photovoltaic cells 200.

Referring now to FIG. 4, a method 240 for forming a conducting layer interconnect 230 is schematically depicted. The method 240 can include a process 242 for forming the first conducting layer 180 over a semiconductor stack 176. In some embodiments, a plurality of layers of conducting material can be sequentially deposited over the semiconductor stack 176 to form the first semiconducting layer 180. Accordingly, the thickness of the first semiconducting layer 180 can span the plurality of layers of conducting material.

The method 240 can include a process 244 for forming the dielectric layer 190 over the first conducting layer 180. Optionally, the dielectric layer 190 can be formed adjacent to the first conducting layer 180. As noted above, the dielectric layer 190 can be significantly thicker than the first conducting layer 180. Moreover, the first conducting layer 180 can be too thin to manufacture using certain manufacturing techniques. For example, it may be desirable to selectively remove portions of the dielectric layer 190. Photolithographic patterning processes can be overly constrained and unsuitable for manufacturing an efficient photovoltaic device. For example, photolithographic processes require the use of chemicals to remove material. However, such chemicals are incompatible with many dielectric and conducting materials. Moreover, photolithographic patterning has too low of a throughput for viable commercial manufacturing of photovoltaic devices. Similarly, certain laser patterning techniques suitable for use to manufacture printed circuit boards (PCB) are unsuitable for manufacturing an efficient photovoltaic device. Such PCB manufacturing commonly makes use of CO₂ laser having wavelengths between 9.1 µm and 10.6 µm, which mandates the use of thick copper layers. The thicknesses of the copper layer usually exceeds 1 mil. The thickness and compositional constraints of the PCB laser techniques are unsuitable for manufacturing an efficient photovoltaic device. Applicants have discovered a new layer structure and laser processing techniques that overcome the deficiencies of photolithographic processing and PCB laser techniques.

Referring still to FIG. 4, the method 240 can include a process 246 for heating an affected region 186 of the first conducting layer 180 with a laser pulse 248. The laser pulse 248 can be selected to promote selective delamination of a portion 196 of the dielectric layer 190 over the affected region 186 of the first conducting layer 180. The laser pulse 248 can have a relative intensity 250 that is substantially Gaussian shaped. The relative intensity 250 can vary across a radial position 252 of the laser pulse 248. The laser pulse 248 can be characterized according to the duration of time of the laser pulse 248. Specifically, a pulse width can define the time between the beginning and end of the laser pulse 248, based on the full width half maximum (FWHM) of the relative intensity 250. In some embodiments, the laser pulse 248 can have a pulse width of less than 5,000 ps such as, for example, less than 1,000 ps in one embodiment, or between 900 fs and 100 ps in another embodiment. As noted above, the wavelength of the laser pulse 248 can be selected to match the partial transmittivity of the dielectric layer 190. Accordingly, the laser pulse 248 can be transmitted through the portion 196 of the dielectric layer 190, particularly at the peak intensity, and to the affected region 186 of the first conducting layer 180.

The method 240 can include a process 254 for melting, at least partially, the affected region 186 of the first conducting layer 180. As a result of the melting of the affected region 186, the affected region 186 can be converted to a contact region 188 formed in the first conducting layer 180. Additionally, as a result of the melting of the affected region 186, the portion 196 of the dielectric layer 190 disposed over the affected region 186 of the first conducting layer 180 can be delaminated to define a via 256 through the portion 196 of the dielectric layer 190. Specifically, the via 256 can be bounded by a via wall 198 formed by the removal of the portion 196 of the dielectric layer 190.

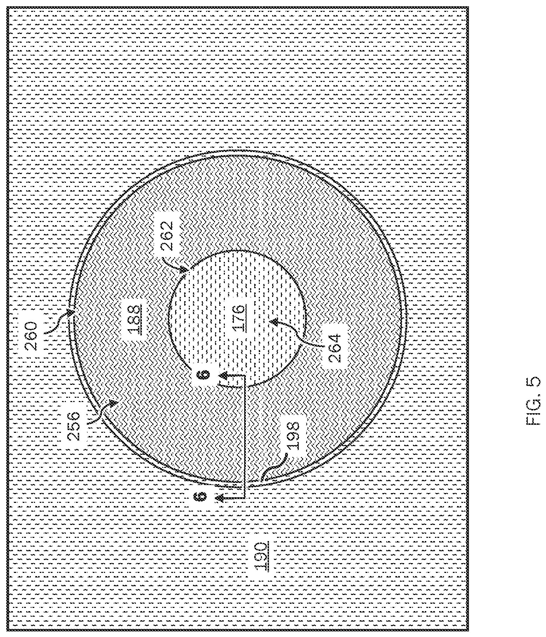

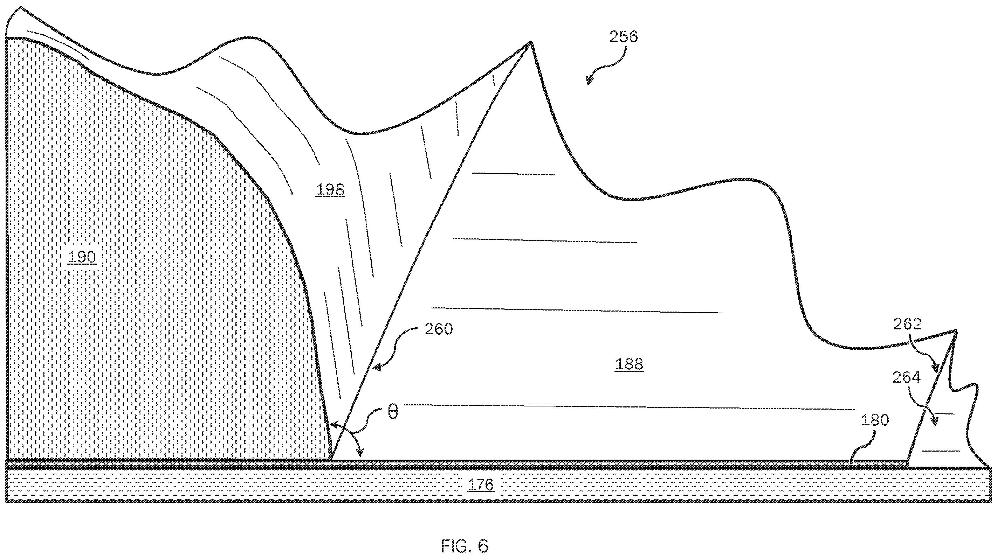

Referring collectively to FIGS. 4, 5, and 6, an exemplary via 256 and contact region 188 are schematically depicted. In some embodiments, the via 256 can be formed near the contact region 188. The via 256 can provide an unobstructed passage to the at least a portion of the contact region 188 suitable for receiving the conducing layer interconnect 230. For example, the via wall 198 of the dielectric layer 190 form a boundary and define an outer edge 260 of the contact region 188. Accordingly, the via wall 198 and the contact region 188 can cooperate to define an enclosure for at least partially surrounding the via 256.

According to present disclosure, the contact region 188 of the first conducting layer 180 can have a substantially flat and annular shape. In some embodiments, the flat shape of the contact region 188 can be observed by comparing the surface area of the contact region 188 to features of the first conducting layer 180. For example, a surface area of the contact region 188 can be substantially larger than the maximum thickness of the first conducting layer 180. In some embodiments, a ratio of the surface area of the contact region 188 to the maximum thickness of the first conducting layer 180 can be at least about 750:1 such as, for example, at least about 1,000:1 in one embodiment, or at least about 1,500:1 in one embodiment. Specifically, in one embodiment, having maximum thickness of the first conducting layer 180 of 2 µm, the surface area of the contact region 188 can be at least about 4,500 µm².

Alternatively or additionally, the flat shape of the contact region 188 can be observed by determining an interface angle θ at the outer edge 260 of the contact region 188. The interface angle θ is defined by the angle formed between the via wall 198 of the dielectric layer 190 and the contact region 188 of the first conducting layer 180, which can be observed by taking a cross section. Generally, the interface angle θ is indicative of the via wall 198 being relatively steep compared to the contact region 188. In some embodiments, the interface angle θ can be larger than about 75° such as, for example, between about 80° and about 135° in one embodiment.

According to the embodiments provided herein, the via 256 can be formed completely through a portion of the first conducting layer 180. For example, an inner edge 262 of the of the contact region 188 can bound a revealed region 264 of the semiconductor stack 176. In some embodiments, the inner edge 262 can be formed by peak of the relative intensity 250 of the laser pulse 248. Accordingly, the inner edge 262 of the of the contact region 188 can be substantially circular.

Referring collectively to FIGS. 2, 5, and 6, the dielectric layer 190 can be significantly thicker than the first conducting layer 180. The average thicknesses the dielectric layer 190 and the first conducting layer 180 can be determined at the cell 200 level. For example, a cross section of the photovoltaic device 100 can be examined. An average thickness of each of the first conducting layer 180 and the dielectric layer 190 can be calculated from the cross section. In some embodiments, a ratio of the average thickness of the dielectric layer 190 in the cell 200 to the average thickness of first conducting layer 180 in the cell 200 can be at least 10:1, such as, for example, greater than about 25:1 in one embodiment, greater than about 50:1 in another embodiment, or greater than about 100:1 in a further embodiment.

Referring still to FIG. 4, the method 240 can include a process 266 for forming the conducting layer interconnect 230. In some embodiments, the process 266 can include depositing the second conducting layer 210 through the via 256. For example, a plurality of layers of conducting material can be sequentially deposited over the via 256 and the dielectric layer 190 to form the second conducting layer 210 and the conducting layer interconnect 230. Accordingly, the conducting layer interconnect 230 can be deposited through the dielectric layer 190 and in contact with the contact region 188 of the first conducting layer 180. In some embodiments, the conducting layer interconnect 230 can form an electrical connection 232 with the contact region 188 of the first conducting layer 180. The electrical connection 232 of the conducting layer interconnect 230 can have a complimentary and corresponding shape to the contact region 188 of the first conducting layer 180. In embodiments, where the via 256 is formed completely through a portion of the first conducting layer 180, the conducting layer interconnect 230 can directly contact the semiconductor stack 176.

It should now be understood that the embodiments provided herein, photovoltaic cells having a conducting layer interconnect formed through a dielectric layer. The conducting layer interconnect can be formed using a laser process. The laser processes described herein can be used to manufacture robust and efficient photovoltaic devices without the drawbacks and constraints of photolithography or PCB manufacturing techniques. For example, the embodiments described herein can be utilized to manufacture photovoltaic devices with thin conducting layers and conducting layer interconnects over a semiconductor stack.

According to the embodiments provided herein, photovoltaic cell of a photovoltaic device can include a first conducting layer, a second conducting layer, a dielectric layer, and a conducting layer interconnect. The first conducting layer and the second conducting layer can be over a semiconductor stack that includes an absorber layer. The first conducting layer can have an average conducting layer thickness. The dielectric layer can be positioned between the first conducting layer and the second conducting layer. The dielectric layer can have an average dielectric layer thickness. The conducting layer interconnect can extend from the second conducting layer and through the dielectric layer. The conducting layer interconnect can form an electrical connection with a contact region of the first conducting layer. The contact region of the first conducting region can have a flat and annular shape. A ratio of the average dielectric thickness to the average conducting layer thickness can be at least 10:1.

In another embodiment, a method for forming a photovoltaic device can include forming a conducting layer over a semiconductor stack. The conducting layer can have a conducting layer thickness. A dielectric layer can be formed over the conducting layer, wherein the dielectric layer has a dielectric layer thickness. An affected region of the conducting layer can be heated with a laser pulse. The affected region of the conducting layer can be, at least partially, melted. The melting can cause a contact region to be formed in the conducting layer and a portion of the dielectric layer disposed over the affected region of the conducting layer to be delaminated to define a via through the portion of the dielectric layer. A ratio of the dielectric layer thickness to the conducting layer thickness can be at least 10:1. A conducting layer interconnect can be formed through the via of the dielectric layer and in contact with the contact region of the conducting layer.

It is noted that the terms "substantially" and "about" may be utilized herein to represent the inherent degree of uncertainty that may be attributed to any quantitative comparison, value, measurement, or other representation. These terms are also utilized herein to represent the degree by which a quantitative representation may vary from a stated reference without resulting in a change in the basic function of the subject matter at issue.

While particular embodiments have been illustrated and described herein, it should be understood that various other changes and modifications may be made without departing from the scope of the claimed subject matter.

## Claims

1. A photovoltaic cell (200) of a photovoltaic device (100) comprising:
a first conducting layer (180) and a second conducting layer (210) over a semiconductor stack (176) comprising an absorber layer (160), wherein the first conducting layer (180) has an average conducting layer thickness and is configured to provide electrical contact with the absorber layer;
a dielectric layer (190) positioned between the first conducting layer (180) and the second conducting layer (210), wherein the dielectric layer (190) has an average dielectric layer thickness; and
a conducting layer interconnect (230) that extends from the second conducting layer (210) and through the dielectric layer (190), wherein:
the conducting layer interconnect (230) forms an electrical connection with a contact region (188) of the first conducting layer (180), and
a ratio of the average dielectric layer thickness to the average conducting layer thickness is at least 10:1,
**characterized in that** the contact region (188) of the first conducting layer (180) has a flat and annular shape.

2. The photovoltaic cell (200) of claim 1, wherein:
the first conducting layer (180) has a maximum thickness,
the contact region (188) of the first conducting layer (180) has a surface area, and
a ratio of the surface area of the contact region (188) to the maximum thickness of the first conducting layer (180) is at least 750:1 µm²/µm.

3. The photovoltaic cell (200) of claim 1, wherein:
the conducting layer interconnect (230) is bounded by a via wall (198) of the dielectric layer (190),
an interface angle θ is defined by the via wall (198) of the dielectric layer (190) and the contact region (188) of the first conducting layer (180),
and the interface angle θ is larger than 75°.

4. The photovoltaic cell (200) of any of claims 1-3, wherein the conducting layer interconnect (230) directly contacts the semiconductor stack (176).

5. The photovoltaic cell (200) of any of claims 1-4, wherein:
the semiconductor stack (176) comprises a back contact layer (170) over the absorber layer (160), and
the first conducting layer (180) is over the back contact layer (170).

6. The photovoltaic cell (200) of any of claims 1-5, wherein a thickness of the first conducting layer (180) is less than 3 µm, or optionally, wherein a thickness of the first conducting layer is between 50 nm to 2.5 µm.

7. The photovoltaic cell (200) of any of claims 1-6, wherein the first conducting layer (180) comprises one or more layers of metal, one or one or more layers of nitrogen-containing metal, or both.

8. The photovoltaic cell (200) of any of claims 1-7, wherein the second conducting layer (210) comprises one or more layers of metal, one or one or more layers of nitrogen-containing metal, or both.

9. The photovoltaic cell (200) of any of claims 1-8, wherein the dielectric layer (190) has greater than 10% transmissivity to wavelengths between 300 nm and 1,100 nm.

10. The photovoltaic cell (200) of any of claims 1-9, wherein the first conducting layer (180) and the second conducting layer (210) have a different material composition.

11. A method for forming a photovoltaic device (100) comprising:
forming a first conducting layer (180) over a semiconductor stack (176) comprising an absorber layer, wherein the first conducting layer (180) has a conducting layer thickness and is configured to provide electrical contact with the absorber layer;
forming a dielectric layer (190) over the first conducting layer (180), wherein the dielectric layer (190) has a dielectric layer thickness;
heating an affected region (186) of the first conducting layer (180) with a laser pulse;
melting, at least partially, the affected region (186) of the first conducting layer (180), whereby a contact region (188) is formed in the first conducting layer (180) and a portion of the dielectric layer (190) disposed over the affected region (186) of the first conducting layer (180) is delaminated to define a via through the portion of the dielectric layer (190), wherein the contact region (188) of the first conducting layer (180) has a flat and annular shape, wherein a ratio of the dielectric layer thickness to the conducting layer thickness is at least 10:1; and
forming a conducting layer interconnect (230) through the via of the dielectric layer (190) and in contact with the contact region (188) of the first conducting layer (180).

12. The method of claim 11, wherein the conducting layer interconnect (230) is formed by depositing a second conducting layer (210) over the dielectric layer (190).

13. The method of any of claims 11 or 12, wherein the dielectric layer (190) has greater than 10% transmissivity to the laser pulse.

14. The method of any of claims 11-13, wherein the laser pulse has a Gaussian shaped relative intensity.

15. The method of any of claims 11-14, wherein the laser pulse has a pulse width of less than 5,000 ps.

## Patentansprüche

1. Photovoltaikzelle (200) einer Photovoltaikvorrichtung (100), die Folgendes umfasst:
eine erste leitende Schicht (180) und eine zweite leitende Schicht (210) über einem Halbleiterstapel (176), der eine Absorberschicht (160) umfasst, wobei die erste leitende Schicht (180) eine mittlere Dicke der leitenden Schicht aufweist und so ausgebildet ist, dass sie einen elektrischen Kontakt mit der Absorberschicht bildet;
eine dielektrische Schicht (190), die zwischen der ersten leitenden Schicht (180) und der zweiten leitenden Schicht (210) angeordnet ist, wobei die dielektrische Schicht (190) eine mittlere Dicke der dielektrischen Schicht aufweist; und
eine leitende Schichtverbindung (230), die sich von der zweiten leitenden Schicht (210) und durch die dielektrische Schicht (190) erstreckt, wobei:
die leitende Schichtverbindung (230) eine elektrische Verbindung mit einer Kontaktregion (188) der ersten leitenden Schicht (180) bildet und
das Verhältnis der mittleren Dicke der dielektrischen Schicht zur mittleren Dicke der leitenden Schicht mindestens 10:1 beträgt,
**dadurch gekennzeichnet, dass** die Kontaktregion (188) der ersten leitenden Schicht (180) flach und ringförmig ist.

2. Photovoltaikzelle (200) nach Anspruch 1, wobei:
die erste leitende Schicht (180) eine maximale Dicke aufweist,
die Kontaktregion (188) der ersten leitenden Schicht (180) eine Oberfläche aufweist und
das Verhältnis der Oberfläche der Kontaktregion (188) zur maximalen Dicke der ersten leitenden Schicht (180) mindestens 750:1 µm²/µm beträgt.

3. Photovoltaikzelle (200) nach Anspruch 1, wobei:
die leitende Schichtverbindung (230) durch eine Durchkontaktwand (198) der dielektrischen Schicht (190) begrenzt ist,
ein Grenzflächenwinkel θ durch die Durchkontaktwand (198) der dielektrischen Schicht (190) und die Kontaktregion (188) der ersten leitenden Schicht (180) definiert ist und der Grenzflächenwinkel θ größer als 75° ist.

4. Photovoltaikzelle (200) nach einem der Ansprüche 1-3, wobei sich die leitende Schichtverbindung (230) in direktem Kontakt mit dem Halbleiterstapel (176) befindet.

5. Photovoltaikzelle (200) nach einem der Ansprüche 1-4, wobei:
der Halbleiterstapel (176) eine Rückkontaktschicht (170) über der Absorberschicht (160) umfasst und
die erste leitende Schicht (180) sich über der Rückkontaktschicht (170) befindet.

6. Photovoltaikzelle (200) nach einem der Ansprüche 1-5, wobei die Dicke der ersten leitenden Schicht (180) weniger als 3 µm beträgt oder wobei gegebenenfalls die Dicke der ersten leitenden Schicht zwischen 50 nm und 2,5 µm beträgt.

7. Photovoltaikzelle (200) nach einem der Ansprüche 1-6, wobei die erste leitende Schicht (180) eine oder mehrere Schichten aus einem Metall, eine oder mehrere Schichten aus einem stickstoffhaltigen Metall oder beides umfasst.

8. Photovoltaikzelle (200) nach einem der Ansprüche 1-7, wobei die zweite leitende Schicht (210) eine oder mehrere Schichten aus einem Metall, eine oder mehrere Schichten aus einem stickstoffhaltigen Metall oder beides umfasst.

9. Photovoltaikzelle (200) nach einem der Ansprüche 1-8, wobei die Durchlässigkeit der dielektrischen Schicht (190) für Wellenlängen zwischen 300 nm und 1100 nm größer als 10 % ist.

10. Photovoltaikzelle (200) nach einem der Ansprüche 1-9, wobei die erste leitende Schicht (180) und die zweite leitende Schicht (210) eine unterschiedliche Materialzusammensetzung aufweisen.

11. Verfahren zur Bildung einer Photovoltaikvorrichtung (100), das Folgendes umfasst:
das Bilden einer ersten leitenden Schicht (180) über einem Halbleiterstapel (176), der eine Absorberschicht umfasst, wobei die erste leitende Schicht (180) eine Dicke der leitenden Schicht aufweist und so ausgebildet ist, dass sie einen elektrischen Kontakt mit der Absorberschicht bildet;
das Bilden einer dielektrischen Schicht (190) über der ersten leitenden Schicht (180), wobei die dielektrische Schicht (190) eine Dicke der dielektrischen Schicht aufweist;
das Erhitzen einer betroffenen Region (186) der ersten leitenden Schicht (180) mit einem Laserimpuls;
das zumindest teilweise Schmelzen der betroffenen Region (186) der ersten leitenden Schicht (180), wodurch eine Kontaktregion (188) in der ersten leitenden Schicht (180) gebildet wird, und ein Abschnitt der dielektrischen Schicht (190), der über der betroffenen Region (186) der ersten leitenden Schicht (180) angeordnet ist, delaminiert wird, wodurch ein Durchkontakt durch den Abschnitt der dielektrischen Schicht (190) definiert wird, wobei die Kontaktregion (188) der ersten leitenden Schicht (180) flach und ringförmig ist, wobei das Verhältnis der Dicke der dielektrischen Schicht zur Dicke der leitenden Schicht mindestens 10:1 beträgt; und
das Bilden einer leitenden Schichtverbindung (230) durch den Durchkontakt der dielektrischen Schicht (190) und in Kontakt mit der Kontaktregion (188) der ersten leitenden Schicht (180).

12. Verfahren nach Anspruch 11, wobei die leitende Schichtverbindung (230) gebildet wird, indem eine zweite leitende Schicht (210) über der dielektrischen Schicht (190) abgeschieden wird.

13. Verfahren nach einem der Ansprüche 11 oder 12, wobei die Durchlässigkeit der dielektrischen Schicht (190) für den Laserimpuls größer als 10 % ist.

14. Verfahren nach einem der Ansprüche 11-13, wobei der Laserimpuls eine gaußförmige relative Intensität aufweist.

15. Verfahren nach einem der Ansprüche 11-14, wobei der Laserimpuls eine Impulsbreite von weniger als 5000 ps aufweist.

## Revendications

1. Cellule photovoltaïque (200) d'un dispositif photovoltaïque (100) comprenant :
une première couche conductrice (180) et une deuxième couche conductrice (210) au-dessus d'un empilement semi-conducteur (176) comprenant une couche absorbante (160), la première couche conductrice (180) ayant une épaisseur moyenne de couche conductrice et étant conçue pour assurer un contact électrique avec la couche absorbante ;
une couche diélectrique (190) positionnée entre la première couche conductrice (180) et la deuxième couche conductrice (210), la couche diélectrique (190) ayant une épaisseur moyenne de couche diélectrique ; et
une interconnexion de couches conductrices (230) qui s'étend depuis la deuxième couche conductrice (210) et à travers la couche diélectrique (190), dans laquelle :
l'interconnexion de couches conductrices (230) forme une connexion électrique avec une région de contact (188) de la première couche conductrice (180), et
un rapport entre l'épaisseur moyenne de couche diélectrique et l'épaisseur moyenne de couche conductrice est d'au moins 10:1,
**caractérisée en ce que** la région de contact (188) de la première couche conductrice (180) a une forme plate et annulaire.

2. Cellule photovoltaïque (200) selon la revendication 1, dans laquelle :
la première couche conductrice (180) présente une épaisseur maximale,
la région de contact (188) de la première couche conductrice (180) présente une superficie, et
un rapport entre la superficie de la région de contact (188) et l'épaisseur maximale de la première couche conductrice (180) est d'au moins 750:1 µm²/µm.

3. Cellule photovoltaïque (200) selon la revendication 1, dans laquelle :
l'interconnexion de couches conductrices (230) est délimitée par une paroi de trou traversant (198) de la couche diélectrique (190),
un angle d'interface θ est défini par la paroi de trou traversant (198) de la couche diélectrique (190) et la région de contact (188) de la première couche conductrice (180),
et l'angle d'interface θ est supérieur à 75°.

4. Cellule photovoltaïque (200) selon l'une quelconque des revendications 1 à 3, dans laquelle l'interconnexion de couches conductrices (230) est en contact direct avec l'empilement semi-conducteur (176).

5. Cellule photovoltaïque (200) selon l'une quelconque des revendications 1 à 4, dans laquelle :
l'empilement semi-conducteur (176) comprend une couche de contact arrière (170) au-dessus de la couche absorbante (160), et
la première couche conductrice (180) se trouve au-dessus de la couche de contact arrière (170).

6. Cellule photovoltaïque (200) selon l'une quelconque des revendications 1 à 5, dans laquelle une épaisseur de la première couche conductrice (180) est inférieure à 3 µm, ou éventuellement dans laquelle une épaisseur de la première couche conductrice se situe entre 50 nm et 2,5 µm.

7. Cellule photovoltaïque (200) selon l'une quelconque des revendications 1 à 6, dans laquelle la première couche conductrice (180) comprend une ou plusieurs couches de métal, une ou plusieurs couches de métal contenant de l'azote, ou les deux.

8. Cellule photovoltaïque (200) selon l'une quelconque des revendications 1 à 7, dans laquelle la deuxième couche conductrice (210) comprend une ou plusieurs couches de métal, une ou plusieurs couches de métal contenant de l'azote, ou les deux.

9. Cellule photovoltaïque (200) selon l'une quelconque des revendications 1 à 8, dans laquelle la couche diélectrique (190) possède une transmissivité supérieure à 10 % pour les longueurs d'onde comprises entre 300 nm et 1100 nm.

10. Cellule photovoltaïque (200) selon l'une quelconque des revendications 1 à 9, dans laquelle la première couche conductrice (180) et la deuxième couche conductrice (210) possèdent des compositions de matière différentes.

11. Procédé destiné à former un dispositif photovoltaïque (100) comprenant :
la formation d'une première couche conductrice (180) au-dessus d'un empilement semi-conducteur (176) comprenant une couche absorbante, la première couche conductrice (180) ayant une épaisseur moyenne de couche conductrice et étant conçue pour assurer un contact électrique avec la couche absorbante ;
la formation d'une couche diélectrique (190) au-dessus de la première couche conductrice (180), la couche diélectrique (190) ayant une épaisseur de couche diélectrique ;
le chauffage d'une région affectée (186) de la première couche conductrice (180) avec une impulsion laser ;
la fusion au moins partielle de la région affectée (186) de la première couche conductrice (180), moyennant quoi une région de contact (188) est formée dans la première couche conductrice (180) et une partie de la couche diélectrique (190) disposée au-dessus de la région affectée (186) de la première couche conductrice (180) est décollée pour définir un trou traversant à travers la partie de la couche diélectrique (190), la région de contact (188) de la première couche conductrice (180) ayant une forme plate et annulaire, un rapport entre l'épaisseur de couche diélectrique et l'épaisseur de couche conductrice étant d'au moins 10:1 ; et
la formation d'une interconnexion de couches conductrices (230) à travers le trou traversant de la couche diélectrique (190) et en contact avec la région de contact (188) de la première couche conductrice (180).

12. Procédé selon la revendication 11, dans lequel l'interconnexion de couches conductrices (230) est formée par dépôt d'une deuxième couche conductrice (210) au-dessus de la couche diélectrique (190).

13. Procédé selon l'une quelconque des revendications 11 et 12, dans lequel la couche diélectrique (190) possède une transmissivité supérieure à 10 % pour l'impulsion laser.

14. Procédé selon l'une quelconque des revendications 11 à 13, dans lequel l'impulsion laser possède une intensité relative de forme gaussienne.

15. Procédé selon l'une quelconque des revendications 11 à 14, dans lequel l'impulsion laser possède une largeur d'impulsion de moins de 5000 ps.
